(19) Europäisches Patentamt
European Patent Office
Office européen des brevets

(11) Veröffentlichungsnummer: **0 129 686**
**B1**

(12) **EUROPÄISCHE PATENTSCHRIFT**

(45) Veröffentlichungstag der Patentschrift: **28.01.87**

(51) Int. Cl.⁴: **H 01 L 39/12**, H 01 L 39/24, H 01 B 12/00

(21) Anmeldenummer: **84105356.4**

(22) Anmeldetag: **11.05.84**

(54) **Supraleitende Faser.**

(30) Priorität: **28.05.83 DE 3319524**

(43) Veröffentlichungstag der Anmeldung: **02.01.85 Patentblatt 85/1**

(45) Bekanntmachung des Hinweises auf die Patenterteilung: **28.01.87 Patentblatt 87/5**

(84) Benannte Vertragsstaaten: **BE FR GB IT NL**

(56) Entgegenhaltungen:
**EP - A - 0 102 489**
**DE - B - 2 856 885**
**FR - A - 2 511 202**

**EXTENDED ABSTRACTS, Band 79-2, Oktober 1979, Princeton, USA; K. BRENNFLECK et al. "Chemical vapor deposition of superconducting niobium carbonitride films on carbon fibres", Seiten 1061-1062**

(73) Patentinhaber: **Kernforschungszentrum Karlsruhe GmbH, Weberstrasse 5 Postfach 3640, D-7500 Karlsruhe 1 (DE)**
Patentinhaber: **BROWN, BOVERI & CIE Aktiengesellschaft, Kallstadter Strasse 1, D-6800 Mannheim 31 (DE)**

(72) Erfinder: **Dustmann, Cord-Heinrich, Dr. Dipl.-Phys., Diemstrasse 10, D-6940 Weinheim (DE)**
Erfinder: **Wahl, Georg Friedrich Hermann, Dr. Dipl.-Phys., Franz-List-Strasse 8, D-6901 Eppelheim (DE)**
Erfinder: **Schmaderer, Franz, Dr. Dipl.-Ing., Türmergasse 13, D-6900 Heidelberg (DE)**
Erfinder: **Fitzer, Erich, Prof. Dr., Haydnplatz 5, D-7500 Karlsruhe (DE)**
Erfinder: **Brennfleck, Karl, Dr., Im HohenGrund 6, D-7500 Karlsruhe (DE)**
Erfinder: **Dietrich, Manfred, Dr. Dipl.-Phys., Trierer Strasse 33, D-7500 Karlsruhe (DE)**
Erfinder: **Paterok, Lienhard, Dipl.-Ing., Schumannstrasse 4, D-7523 Graben-Neudorf1 (DE)**

(74) Vertreter: **Kempe, Wolfgang, Dr. et al, c/o Brown, Boveri & Cie AG Postfach 351, D-6800 Mannheim 1 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



ACTORUM AG

**Beschreibung**

Die Erfindung betrifft eine supraleitende Faser eines supraleitenden Faserbündels, bei welcher die Mantelfläche einer Trägerfaser von einer supraleitenden Schicht umhüllt ist.

Bei der Weiterentwicklung der Energietechnik im Hinblick auf die Kernfusion und auf supraleitende Generatoren, der Verkehrstechnik (Magnetschwebebahn), der Umwelttechnik (Kohlenentschwefelung) und der Hochenergiephysik werden Starkfeldmagnete benötigt, die unter wirtschaftlichen Gesichtspunkten nur auf Supraleiterbasis hergestellt werden können.

Insbesondere für derartige Anwendungen wurden geeignete, einen hohen Elastizitätsmodul aufweisende Trägerfasern (z.B. C,B,Stahl) mit supraleitendem Material beschichtet und zu Faserbündeln, die eine beliebige Anzahl von Einzelfasern enthalten, zusammengefasst. Die Trägerfasern dienen als zugfeste Matrix und als Substrat für den Auftrag der supraleitenden Schicht. Als aussichtsreiches Supraleitungsmaterial sind z.B. Niobcarbonitride und Nioboxycarbonitride der allgemeinen Formel

$$NbC_xN_yO_z \text{ (x + y + z kleiner/gleich 1)}$$

bekanntgeworden. Derartige Niobverbindungen zeichnen sich durch hohe kritische Temperaturen, hohe kritische Magnetfelder und hohe kritische Stromdichten aus. Sie lassen sich durch ein chemisches Gasabscheideverfahren (CVD-Chemical Vapor Deposition), bei dem das Niob durch Reaktion von $NbCl_5$ in Gegenwart von kohlenstoff- und stickstoffhaltigen Gasen als dünner Film abgeschieden wird, auf die Trägerfaser aufbringen. Der CVD-Prozell wird dabei entweder einstufig (gleichzeitige Nb-Abscheidung und Carbonitrierung) oder zweistufig (Nb-Abscheidung und Carbonitrierung zeitlich aufeinanderfolgend) durchgeführt.

Durch die DE-AS 2 856 885 und die Veröffentlichung «Chemical Vapor Deposition of Superconducting Niobium Carbonitride Films on Carbon Fibres», K. Brennfleck, M. Dietrich, E. Fitzer, D. Kehr, Proc. of CVD — 7th, Int. Conf., 300-314, The Electrochem. Soc., Princeton, NY, (1979) ist ein derartiges zweistufiges CVD-Verfahren bekanntgeworden. Ferner sind die Veröffentlichung «CVD Processing of Carbon Fiber Superconductors», M. Dietrich, C.-H. Dustmann, F. Schmaderer, G. Wahl, Presented on the Applied Superconductivity Conference, 1982, Knoxville, Paper MB 2 weitere verbesserte Verfahren vorgeschlagen worden, die zur Herstellung von supraleitenden Faserbündeln geeignet sind. Nach diesen verbesserten Verfahren hergestellte supraleitende Faserbündel weisen eine homogene Beschichtung der einzelnen Fasern des Faserbündels auf. Ihre supraleitenden Schichten sind extrem feinkörnig, so dass sich hohe kritische Magnetfelder und hohe kritische Stromdichten einstellen.

Es zeigte sich jedoch bei der Herstellung von supraleitenden Fasern, dass es sehr schwierig ist, eine ausreichende Haftung der supraleitenden Schicht auf der Trägerfaser zu erreichen. Dieses Problem tritt mehr oder weniger bei jedem Trägerfasertyp oder Supraleitertyp auf. Ein Grund hierfür liegt in dem unterschiedlichen thermischen Ausdehnungskoeffizienten von Trägerfaser und supraleitender Schicht. Eine andere Ursache ist darin zu suchen, dass bei der Beschichtung der Trägerfasern im CVD-Prozess erhitzte, reaktive Gase wie Wasserstoffgas oder Ammoniak die Faseroberfläche angreifen bzw. unerwünschte Kohlenwasserstoffverbindungen auf der Faseroberfläche bilden und eine gute Haftung der supraleitenden Schicht erschweren.

Die mangelhafte Haftung der supraleitenden Schicht auf der Trägerfaser führt zu Rissen in der supraleitenden Schicht und unter Umständen zu deren Abblättern. Dies ist nachteilhaft, da Unterbrechungen in der supraleitenden Schicht durch Risse oder Lücken eine Reduzierung der kritischen Stromdichte der supraleitenden Faser zur Folge hat.

Durch Anwendung des oben erwähnten zweistufigen CVD-Verfahrens konnten diese Probleme für Trägerfasern aus Kohlefasern hoher Zugfestigkeit (HT-Kohlenstoffasern) nur teilweise gelöst werden. Dagegen war eine zufriedenstellende Beschichtung von Hochmodulfasern (HM-Kohlenstoffasern), das sind Kohlenstoffasern mit besonders hoher Grafitierung und einem demzufolge hohen Elastizitätsmodul, bisher nicht möglich. HM-Kohlenstoffasern zeichnen sich jedoch durch eine bessere mechanische Kompatibilität mit Niobcarbonitrid bzw. Nioboxycarbonitrid aus, als HT-Kohlenstoffasern, so dass ihre Verwendung als Trägerfaser besonders wünschenswert ist.

Aufgabe der Erfindung ist es, supraleitende Fasern der eingangs genannten Art sowie Verfahren zu deren Herstellung anzugeben, bei denen die Haftung der supraleitenden Schicht auf der Trägerfaser verbessert wird und bei denen eine Verwendung von Hochmodulfasern ermöglicht wird.

Diese Aufgabe wird erfindungsgemäss dadurch gelöst, dass die Mantelfläche der Trägerfaser durch eine Basisschicht aus einem Carbid abgedeckt ist, auf der die supraleitende Schicht haftet. Die Basisschicht besteht vorzugsweise aus Siliziumcarbid SiC, Wolframcarbid $W_2C$ oder Titancarbid TiC. Beispielsweise sind SiC-Basisschichten oxidationsfest und halten korrodierenden Einflüssen bei erhöhten Temperaturen stand, so dass ein chemischer Angriff der Kohlenstoffaser bei der Beschichtung mit Niobcarbonitrid oder Nioboxycarbonitrid in einem CVD-Prozess vermindert wird. Eine SiC-Basisschicht vermindert ausserdem wegen ihres günstigen thermischen Ausdehnungskoeffizienten die Spannungen zwischen dem Kohlenstoffasersubstrat und der supraleitenden Schicht.

Eine weitere erfinderische Lösung der gestellten Aufgabe ist dadurch gegeben, dass die Mantelfläche der Trägerfaser durch eine Basisschicht aus einem Oxid abgedeckt ist, auf der die supraleitende Schicht haftet. Vorteilhafte Oxide sind Aluminiumoxid $Al_2O_3$ oder Zirkoniumdioxid $ZrO_2$.

Die Basisschicht soll möglichst eine geschlossene, die Trägerfaser abdeckende Schicht bilden. Andererseits soll sie möglichst dünn sein.

Zur Herstellung von supraleitenden Fasern findet erfindungsgemäss ein chemisches Gasphasenabscheideverfahren (CVD-Verfahren) Anwendung, bei dem eine Beschichtung von Trägerfasern erfolgt und

auf die Trägerfasern das Carbid bzw. Oxid der Basisschicht, gegebenenfalls im Anschluss an eine Reinigungsbehandlung der Trägerfaser, abgeschieden wird. Hieran schliesst sich ein bekanntes ein- bzw. zweistufiges CVD-Verfahren zur Abscheidung der supraleitenden Schicht, wie es dem zitierten Stand der Technik entnehmbar ist, an. Beispielsweise wird Nioboxycarbonitrid der allgemeinen Formel

$$NbC_xN_yO_z \text{ (x + y + z kleiner/gleich 1)}$$

mit Hilfe der chemischen Abscheidung aus der Gasphase durch Reaktion von Niobchlorid, Kohlenstoff- und Stickstoffverbindungen auf ein Kohlenstoffträgerbündel abgeschieden.

Vorteilhaft ist es, bei der Abscheidung der Basisschicht als Reaktionsgas ein Gasgemisch zu verwenden, welches ein Chlorid bzw. Oxid enthält. Als Reaktionsgase sind beispielsweise Siliziummethyltrichlorid $CH_3SiCl_3$ oder Gasgemische von Titantetrachlorid, Wolframhexachlorid oder Aluminiumtrichlorid mit Methan geeignet.

Anhand der Zeichnung, in der ein Ausführungsbeispiel der Erfindung sowie eine Vorrichtung zur Durchführung des Herstellungsverfahrens gezeigt sind, sollen weitere vorteilhafte Ausgestaltungen und Weiterbildungen der Erfindung näher erläutert und beschrieben werden.

Es zeigt:

Fig. 1 eine erfindungsgemässe supraleitende Faser im Querschnitt und

Fig. 2 eine CVD-Apparatur zur Herstellung erfindungsgemässer supraleitender Fasern.

Die stark vergrösserte, schematische Darstellung des Querschnittes einer erfindungsgemässen supraleitenden Faser gemäss Fig. 1 zeigt eine Kohlenstofffaser 11, die als Trägerfaser dient, und auf der verschiedene, konzentrisch angeordnete Schichten aufgetragen sind. Der Durchmesser der Kohlenstoffaser 11 liegt z.B. bei 7 Mikrometer. Auf die Kohlenstofffaser 11 ist eine Basisschicht 12 aus Siliziumcarbid SiC mit einer Schichtdicke zwischen 30 und 80 nm (vorzugsweise 40 bis 50 nm) aufgebracht. Die Basisschicht 12 ihrerseits trägt eine supraleitende Schicht 13, die aus einem Niobcarbonitrid Nb (C,N) oder einem Nioboxycarbonitrid $NbC_xN_yO_z$ besteht und Schichtdicken zwischen 100 und 1000 nm annehmen kann. Die supraleitende Schicht 13 ist durch einen Mantel 14 aus hochreinem Kupfer bzw. Aluminium abgedeckt, dessen Schichtdicke bei 1000 nm liegen kann. Dieser Mantel 14 dient der elektrischen Stabilisierung der supraleitenden Faser und trägt im normalleitenden Zustand der Faser den elektrischen Strom.

Die Fig. 2 zeigt eine Abscheideapparatur, mittels der durch Auftrag einer Basisschicht 12 aus Kohlenstoffasern und anschliessender Nioboxycarbonitridabscheidung und Verkupferung der einzelnen Fasern ein aus vielen erfindungsgemässen Einzelfasern bestehendes supraleitendes Faserbündel herstellbar ist.

In einer Abspulkammer 20 befindet sich eine Rohmaterialspule, mit unbeschichteten Trägerfasern 11 (Kohlenstoffaserbündel). Die Trägerfasern 11 werden durch eine Fasertransporteinrichtung 22 durch ein mehrfach abgewinkeltes Quarzrohr 23, in dem die Beschichtung der Trägerfasern 11 erfolgt, gezogen. Die beschichteten Fasern 24 werden auf eine in einer Aufspulkammer 25 befindliche Aufnahmespule aufgehaspelt. In dem Quarzrohr 23 befinden sich vier Gaseinlassstutzen 26, 27, 28, 29 durch die Stickstoff $N_2$, ein Gemisch aus Argon Ar (welches als Trägergas dient) und Siliziummethyltrichlorid $CH_3SiCl_3$, ein Gemisch aus Wasserstoff und Stickstoff $H_2/N_2$ bzw. ein Gemisch aus Methan und Ammoniak $CH_4/NH_3$ in das Quarzrohr 23 eingelassen werden können. Über drei Pumpstutzen 30, 31, 32 lässt sich das innerhalb des Quarzrohres 23 befindliche Gas abpumpen und ein Unterdruck herstellen. Durch zwei Drosselstellen 33, 34, durch die sich das Faserbündel ziehen lässt, wird ein Druckausgleich im Quarzrohr 23 verhindert, so dass sich innerhalb des Quarzrohres 23 unterschiedliche Drücke jeweils vor und hinter den Drosselstellen 33, 34 einstellen können und eine Vermischung der unterschiedlichen Gase vermieden wird.

Während ihres Transportes von der Abspulkammer 20 zur Aufspulkammer 25 tritt das Faserbündel durch fünf Öfen 35, 36, 37, 38, 39. Im ersten Ofen 35 werden die Kohlenstoffasern 11, falls notwendig, gereinigt, indem sie in einer Stickstoff- oder Wasserstoffatmosphäre aufgeheizt werden. Die Gaszuflussmenge in den Gaseinlassstutzen 26 liegt beispielweise zwischen 1 und 20 Liter pro Stunde. Die Ofentemperatur wird auf 600 bis 1000°C eingestellt.

Im zweiten Ofen 36 erfolgt der erfindungsgemässe Auftrag einer Zwischenschicht mittels Abscheidung von Siliziumcarbid SiC aus der Gasphase von Siliziummethyltrichlorid $CH_3SiCl_3$. Siliziummethyltrichlorid strömt durch den Gaseinlassstutzen 27 in das Quarzrohr 23 und zerfällt im Ofen 36 bei einem Partialdruck von etwa 50 mbar und einer Temperatur zwischen 1000 und 1100°C in Siliziumcarbid SiC und Chlorwasserstoff HCl, wobei sich das Siliziumcarbid auf der gereinigten Kohlenstoffaseroberfläche gleichmässig abscheidet. Das verbrauchte Gas wird über einen Pumpstutzen 30 abgepumpt, wobei der Gasdruck des Gasgemisches aus Argon und Siliziummethyltrichlorid auf ca. 1000 mbar eingestellt wird.

Im dritten Ofen 37 werden die Fasern aus einem $NbCl_5$-$H_2$-$N_2$-Gasgemisch mit einer Nb-haltigen Verbindung beschichtet. Hierfür strömt durch den Gaseinlassstutzen 28 ein Wasserstoff-Stickstoff-Gemisch in das Quarzrohr 23 mit einer Zuflussmenge, die zwischen 2 und 20 Liter pro Stunde liegt, ein. Das $NbCl_5$ wird aus einem Feststoffverdampfer 40, der jedoch auch durch einen Verdampfer aus der flüssigen Phase ersetzt werden kann, in die Gasphase überführt und mit dem Wasserstoff-Stickstoff-Gemisch in den Reaktor geleitet. Die Temperatur des Feststoffverdampfers wird hierbei auf einen Wert zwischen 80 und 200°C eingestellt. Das Niobchlorid kann jedoch auch durch direkte Chlorierung von Niob hergestellt werden. Die Temperatur des Ofens 37 liegt zwischen 600 und 1000°C. Das Restgas wird über den Pumpstutzen 31 abgepumpt.

Im vierten Ofen 38 erfolgt die zweite Stufe des CVD-Verfahrens zur Herstellung der supraleitenden Schicht. Durch den Gaseinlassstutzen 29 wird ein

kohlenstoff- und stickstoffhaltiges Gasgemisch (z.B. 0 bis 50 Vol.-% Methan, 0 bis 50 Vol.-% Ammoniak und der Rest Stickstoff) in das Quarzrohr 23 eingelassen. Die Zuflussmenge von Methan und Ammoniak liegt jeweils zwischen 2 und 15 Liter pro Stunde. Der vierte Ofen 38 wird auf eine Temperatur zwischen 700 und 1100°C temperiert. Dabei dissoziieren die Gase Methan und Ammoniak und es dringen Kohlenstoff und Stickstoff in die Niobschicht ein. Das Restgas wird über den Pumpstutzen 32 abgesaugt.

Im Prinzip kann in der Abscheideapparatur auch einstufig gearbeitet werden, d.h. im Ofen 37 wird gleichzeitig Niob abgeschieden und in einer kohlenstoff- und stickstoffhaltigen Atmosphäre carbonitriert.

Das Quarzrohr 23 (Reaktor) und die Gasversorgung ist durch geeignet angebrachte Strömungswiderstände (Drosselstellen 33, 34) und geeignete Auslegung der Pumpen die an die Pumpstutzen 30, 31, 32 angeschlossen sind, so konstruiert, dass die Gase in den Öfen 35, 36, 37, 38 jeweils in Pfeilrichtung strömen.

Die Niobabscheidung in dem Ofen 37 erfolgt unter Plasmaaktivierung. Hierfür ist dem Ofen 37 eine HF-Spule 41 vorgeschaltet (gemäss der Gasströmungsrichtung im Quarzrohr). Die HF-Spule 41 wird durch einen HF-Generator 42 mit einer Frequenz von 13,65 MHz gespeist. Die Leistung des HF-Generators 42 liegt beispielsweise zwischen 5 und 100 Watt. Die Spule 41 hat beispielsweise eine Länge von 80 mm, einen Durchmesser von 55 mm und trägt dreizehn Windungen. Die Plasmaaktivierung kann auch — was nicht dargestellt wurde — kapazitiv oder durch eine Gleichstromentladung erfolgen. Hierfür stehen sich zwei im Quarzrohr 23 radial gegenüberliegende Metallstäbe bzw. Platten als Elektroden gegenüber. Durch die HF-Spule bzw. die Elektroden werden die Reaktanten (Gase) innerhalb des Quarzrohres 23 in einen angeregten oder ionisierten Zustand gebracht. Die Gasentladung kann kontinuierlich oder pulsierend angeregt werden.

Die Niobabscheidung im Ofen 37 kann auch unter Einwirkung eines Ultraschallfeldes erfolgen. Das Ultraschallfeld kann beispielsweise durch einen Piezo-Kristall 43 erzeugt und an einem Schallreflektor 44 reflektiert werden.

Der Quarzrohrabschnitt zwischen Feststoffverdampfer 40 und Ofen 37 wird zweckmässigerweise zur Aufrechterhaltung der Gastemperatur thermostabilisiert. Dies wurde durch eine strich-punktierte Linie 45 angedeutet.

In dem Ofen 39 werden die supraleitenden Schichten des Faserbündels mit einer hochleitenden Kupferschicht 14 überzogen. Dies erfolgt durch einen CVD-Process, bei dem Kupfer aus der Gasphase auf die Fasern abgeschieden wird. Der Ofen 39 kann so temperiert werden, dass die Fasern kälter als das abzuscheidende Kupfer sind.

## Patentansprüche

1. Supraleitende Faser eines supraleitenden Faserbündels, bei welcher die Mantelfläche einer Trägerfaser (11) von einer supraleitenden Schicht (13) umhüllt ist, dadurch gekennzeichnet, dass die Mantelfläche der Trägerfaser (11) durch eine Basisschicht (12) aus einem Carbid abgedeckt ist, auf der die supraleitende Schicht (13) haftet.

2. Supraleitende Faser nach Anspruch 1, dadurch gekennzeichnet, dass die Basisschicht (12) aus Siliziumcarbid SiC besteht.

3. Supraleitende Faser nach Anspruch 1, dadurch gekennzeichnet, dass die Basisschicht (12) aus Wolframcarbid $W_2C$ besteht.

4. Supraleitende Faser nach Anspruch 1, dadurch gekennzeichnet, dass die Basisschicht (12) aus Titancarbid TiC besteht.

5. Supraleitende Faser eines supraleitenden Faserbündels, bei welcher die Mantelfläche einer Trägerfaser (11) von einer supraleitenden Schicht (13) umhüllt ist, dadurch gekennzeichnet, dass die Mantelfläche der Trägerfaser (11) durch eine Basisschicht (12) aus einem Oxid abgedeckt ist, auf der die supraleitende Schicht (13) haftet.

6. Supraleitende Faser nach Anspruch 5, dadurch gekennzeichnet, dass die Basisschicht (12) aus Aluminiumoxid $Al_2O_3$ besteht.

7. Supraleitende Faser nach Anspruch 5, dadurch gekennzeichnet, dass die Basisschicht (12) aus Zirkoniumdioxid $ZrO_2$ besteht.

8. Verfahren zur Herstellung von supraleitenden Fasern nach einem der Ansprüche 1 bis 7, bei dem eine supraleitende Schicht (13), insbesondere Niobcarbonitrid oder Nioboxycarbonitrid mit Hilfe der chemischen Abscheidung aus der Gasphase, insbesondere durch Reaktion von Niobchlorid, Kohlenstoff- und Stickstoffverbindungen, auf der Trägerfaser (11) abgeschieden wird, dadurch gekennzeichnet, dass das Carbid bzw. Oxid der Basisschicht (12) gegebenenfalls im Anschluss an eine Reinigungsbehandlung der Trägerfaser mit Hilfe der chemischen Abscheidung aus der Gasphase auf die Trägerfaser (11) abgeschieden wird und sich die Abscheidung der supraleitenden Schicht (13) anschliesst.

9. Verfahren nach Anspruch 8, dadurch gekennzeichnet, dass das Reaktionsgasgemisch bei der Abscheidung der Basisschicht ein Chlorid enthält.

10. Verfahren nach Anspruch 8, dadurch gekennzeichnet, dass das Reaktionsfasgemisch bei der Abscheidung der Basisschicht ein Oxid enthält.

## Claims

1. Superconducting fibre of a superconducting fibre bundle in which the sheath surface of a carrier fibre (11) is enrobed by a superconducting layer (13), characterized in that the sheath surface of the carrier fibre (11) is covered by a base layer (12) of a carbide to which the superconducting layer (13) adheres.

2. Superconducting fibre according to Claim 1, characterized in that the base layer (12) consists of silicon carbide SiC.

3. Superconducting fibre according to Claim 1, characterized in that the base layer (12) consists of tungsten carbide $W_2C$.

4. Superconducting fibre according to Claim 1,

characterized in that the base layer (12) consists of titanoum carbide TiC.

5. Superconducting fibre of a superconducting fibre bundle in which the sheath surface of a carrier fibre (11) is enrobed by a superconducting layer (13), characterized in that the sheath surface of the carrier fibre (11) is covered by a base layer (12) of an oxide to which the superconducting layer (13) adheres.

6. Superconducting fibre according to Claim 5, characterized in that the base layer (12) consists of aluminium oxide $Al_2O_3$.

7. Superconducting fibre according to Claim 5, characterized in that the base layer (12) consists of zirconium dioxide $ZrO_2$.

8. Process for preparing superconducting fibres according to any one of Claims 1 to 7, wherein a superconducting layer (13), in particular niobium carbonitride or niobium oxycarbonitride, is deposited on the carrier fibre (11) by means of chemical deposition from the gas phase, in particular by reaction of niobium chloride, carbon compounds and nitrogen compounds, characterized in that the carbide or oxide of the base layer (12) is deposited on the carrier fibre (11), if desired after a cleaning treatment of the carrier fibre, by means of chemical deposition from the gas phase, and the deposition of the superconducting layer (13) follows.

9. Process according to Claim 8, characterized in that the reaction gas mixture in the deposition of the base layer contains a chloride.

10. Process according to Claim 8, characterized in that the reaction gas mixture in the deposition of the base layer contains an oxide.

**Revendications**

1. Fibre supraconductrice d'un faisceau de fibres supraconducteur, dans laquelle la surface latérale d'une fibre porteuse (11) est enrobée d'une couche supraconductrice (13), caractérisée en ce que la surface latérale de la fibre porteuse (11) est recouverte par une couche de base (12) en un carbure, à laquelle adhère la couche supraconductrice (13).

2. Fibre supraconductrice conforme à la revendication 1, caractérisée en ce que la couche de base (12) est constituée de carbure de silicium SiC.

3. Fibre supraconductrice conforme à la revendication 1, caractérisée en ce que la couche de base (12) est constituée de carbure de tungstène $W_2C$.

4. Fibre supraconductrice conforme à la revendication 1, caractérisée en ce que la couche de base (12) est constituée de carbure de titane TiC.

5. Fibre supraconductrice d'un faisceau de fibres supraconducter, dans laquelle la surface latérale d'une fibre porteuse (11) est enrobée d'une couche supraconductrice (13), caractérisée en ce que la surface latérale de la fibre porteuse (11) est recouverte d'une couche de base (12) en un oxyde, à laquelle adhère la couche supraconductrice (13).

6. Fibre supraconductrice conforme à la revendication 5, caractérisée en ce que la couche de base (12) est constituée doxyde d'aluminium $Al_2O_3$.

7. Fibre supraconductrice conforme à la revendication 5, caractérisée en ce que la couche de base (12) est constituée de dioxyde de zirconium $ZrO_2$.

8. Procédé de fabrication de fibres supraconductrices conforme à l'une des revendications 1 à 7, dans lequel on dépose, sur la fibre porteuse (11), une couche supraconductrice (13), en particulier du carbonitrure de niobium ou de l'oxycarbonitrure de niobium, par dépôt chimique à partir de la phase gazeuse, en particulier par réaction du chlorure de niobium, de composés carbonés et de composés azotés, caractérisé en ce que l'on dépose sur la fibre porteuse (11), éventuellement à la suite d'un traitement de nettoyage de la fibre porteuse, par dépôt chimique à partir de la phase gazeuse, le carbure ou l'oxyde de la chouche de base (12), et qu'y fait suite le dépôt de la couche supraconductrice (13).

9. Procédé conforme à la revendication 8, caractérisé en ce que, lors du dépôt de la couche de base, le mélange réactionnel gazeux contient un chlorure.

10. Procédé conforme à la revendication 8, caractérisé en ce que, lors du dépôt de la couche de base, le mélange gazeux réactionnel contient un oxyde.

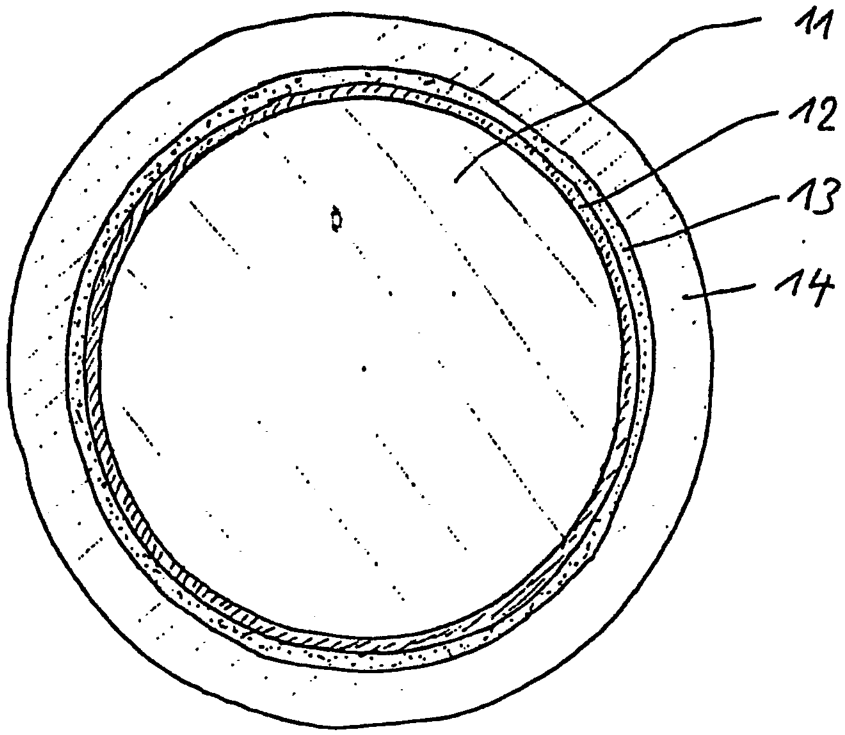


Fig.1

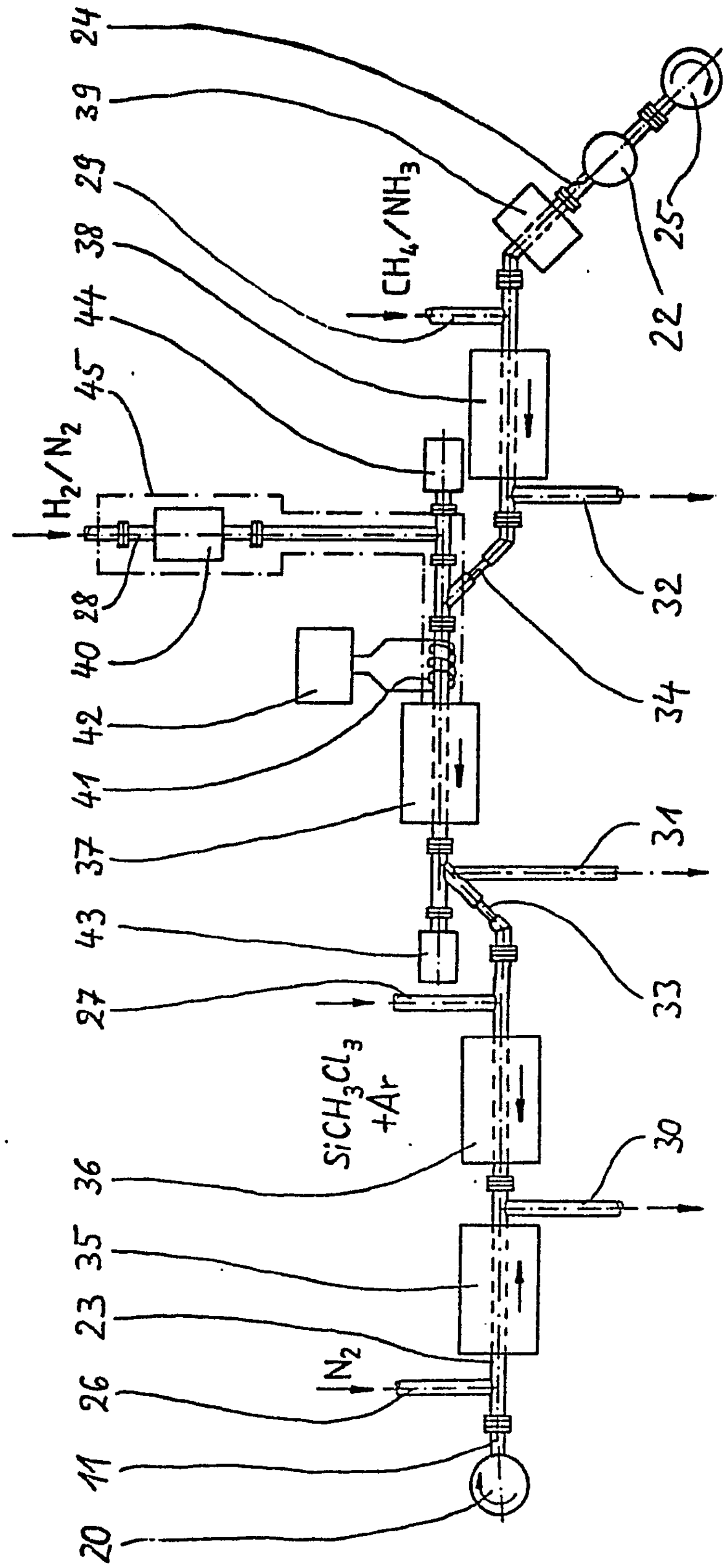

24
39
29
38
44
45
CH4/NH3
H2/N2
28
40
42
41
37
43
27
SiCH3Cl3
+Ar
36
35
23
26
N2
11
20
25
22
32
34
31
33
30


Fig. 2